(19) **Europäisches Patentamt / European Patent Office / Office européen des brevets**

(11) **EP 2 116 855 B1**

(12) **EUROPÄISCHE PATENTSCHRIFT**

(45) Veröffentlichungstag und Bekanntmachung des Hinweises auf die Patenterteilung:
**10.06.2015 Patentblatt 2015/24**

(51) Int Cl.:
*G01R 15/20* *(2006.01)* *G01R 33/025* *(2006.01)*

(21) Anmeldenummer: **09157865.8**

(22) Anmeldetag: **14.04.2009**

(54) **Strommesseinrichtung**

Current measuring device

Dispositif de mesure de courant

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **17.04.2008 AT 6142008**

(43) Veröffentlichungstag der Anmeldung:
**11.11.2009 Patentblatt 2009/46**

(73) Patentinhaber: **Adaptive Regelsysteme Gesellschaft mbH**
**5020 Salzburg (AT)**

(72) Erfinder: **Leikermoser, Albert**
**5020 Salzburg (AT)**

(74) Vertreter: **Patentanwälte Pinter & Weiss OG**
**Prinz-Eugen-Straße 70**
**1040 Wien (AT)**

(56) Entgegenhaltungen:
EP-A1- 1 811 311    EP-A2- 0 772 046
EP-A2- 1 182 461    WO-A1-2005/073744
DE-B- 1 170 537    US-A1- 2006 033 487
US-A1- 2007 200 564

**Beschreibung**

Die gegenständliche Erfindung betrifft eine Strommesseinrichtung und Verfahren zur galvanisch getrennten Messung von Strömen mit einem Aufnahmeteil aus einem Material mit magnetischer Permeabilität im Bereich der ferromagnetischen oder weichmagnetischen Materialien auf dem an einer Seite eine Mehrzahl von Sensoren zur Messung der im Wesentlichen orthogonal zum Aufnahmeteil ausgerichteten Magnetfelder angeordnet sind, wobei eine Auswerteeinheit vorgesehen ist, die die Messsignale der Sensoren zur Bestimmung des zu messenden Stromes auswertet, sowie die Anwendung der Strommesseinrichtung in einem Isolator.

Speziell bei der Strommessung in Mittel- und/oder Hochspannungsanlagen tritt das Problem auf, dass bei üblichen bekannten Strommesseinrichtungen, wie beispielsweise bei konventionellen toroidförmigen Stromwandlern, der stromführende Leiter entweder durch das Toroid durchgefädelt werden muss oder das Toroid in Form von zwei Halbtoroiden (Split Type) über den stromführenden Leiter geklappt werden kann. In beiden Fällen ist die im Stromwandler integrierte Messwicklung vom stromführenden Leiter des Primärkreises (also des Messobjektes) unter Bedachtnahme allfälliger Überspannungen mit hohem Isolationsaufwand und unter Berücksichtigung hoher Isolationssicherheit zu trennen.

Im Falle von teilbaren Stromwandlern (Split Type) tritt zusätzlich das Problem auf, dass die beim Zusammenfügen der beiden Halbtoroide aufgrund von Bearbeitungstoleranzen sich zwangsweise ergebenden Luftspalte zu minimieren sind, da gerade diese Restluftspalte einen sehr starken Einfluss auf die resultierende Messgenauigkeit der Strommesseinrichtung haben.

Die nicht teilbaren toroidalen Stromwandler haben somit den Vorteil der höheren und reproduzierbaren Messgenauigkeit, aber den Nachteil der niedrigen Montagefreundlichkeit wegen des notwendigen "Durchfädelns" des stromführenden Leiters durch das Toroid, während die "Split Types" zwar montagefreundlicher sind, aber andererseits hohe Anforderungen an die exakte Montage sowie an die Minimierung der Bearbeitungstoleranzen im Luftspaltbereich haben, um ausreichende Messgenauigkeit erzielen zu können. Beiden Typen ist obendrein der notwendigerweise hohe Isolationsaufwand gemein.

Außerdem haben Stromwandler, die nach dem Prinzip eines geschlossenen magnetischen Kreises aus ferromagnetischem Material bestehen, den Nachteil, dass beim Messen kleiner Ströme aufgrund der meist geringen Anfangspermeabilität oft große relative Messfehler auftreten. Obendrein können bei derartigen Stromwandlern im Falle geringer DC-Anteile im zu messenden Stromsignal auch magnetische Sättigungseffekte im geschlossenen Eisenkreis auftreten und dadurch exorbitante Messfehler entstehen.

Auch beim Einsatz von hinlänglich bekannten Rogowskispulen ergeben sich dieselben Probleme bezüglich Anwenderfreundlichkeit (Split Type) und Messgenauigkeit wie in den obigen Ausführungen erläutert.

Alle oben geschilderten Prinzipien zur Strommessung haben einen gemeinsamen gravierenden Nachteil, nämlich dass die Messeinrichtung den stromführenden Leiter, also das Messobjekt, in Form eines geschlossenen Linienzuges zur Gänze und weitgehend unterbrechungsfrei umschließen muss.

Aus der WO 01/23899 A1 ist wiederum eine Strommesseinrichtung bekannt, die zwei Hall-Sensoren verwendet, um eine Differenzspannung zu messen. Das Leiterblech wird dabei so ausgebildet und die beiden Hall-Sensoren so angeordnet, dass die Hall-Sensoren von gegensinnig orientierten Magnetfeldern durchsetzt werden. Durch die Differenzbildung werden Spannungsanteile, die am Ort des Differenzsensors keine Differenz aufweisen, wie z.B. hervorgerufen durch das Erdmagnetfeld oder Streufelder von benachbarten parallelen stromführenden Leitern, nicht gemessen. Nicht parallel liegende Leiter beeinflussen aber sehr wohl die Messung mit einer solchen Strommesseinrichtung, weshalb die Anwendbarkeit dieser Einrichtung diesbezüglich beschränkt ist.

Die FR 2 698 695 A2 zeigt einen Isolator mit einer darin integrierten Strom- und Spannungsmesseinrichtung. Die Spannungsmesseinrichtung ist als kapazitiver Spannungssensor ausgestaltet. Die Strommesseinrichtung wird aus einer Spule gebildet, die in einem Hohlraum im Isolator angeordnet ist. Mit einer solchen Anordnung einer Strommesseinrichtung muss die Strommessspule nicht mehr eigens isoliert werden. Allerdings weist eine einzelne Spule eine hohe Fremdempfindlichkeit auf, d.h. Fremdfelder beeinflussen direkt die Strommessung, was die Messgenauigkeit verringert.

Die EP 0 772 046 A2 zeigt einen Magnetfeldsensor, welcher beispielsweise als Stromsensor genutzt werden kann. Mithilfe zweier Flusskonzentratoren, welche durch einen Luftspalt voneinander getrennt sind, werden die Feldlinien eines Magnetfeldes durch die Hallelemente geleitet. Die beiden Hallelemente sind auf dem magnetischen Körper angeordnet, wodurch sich der Magnetische Fluss über den Luftspalt minimiert und somit das Messergebnis weniger verfälscht wird. Weiters ist ein ferromagnetisches Joch vorgesehen, welches den elektrischen Leiter, für welchen die Strommessung vorgesehen ist umschließt. Das Joch und die Flusskonzentratoren bilden einen magnetischen Kreis und leiten das entstehende Magnetfeld bestmöglich durch die Hallelemente. Auch diese Anordnung weist eine gewisse Fremdempfindlichkeit auf.

Es ist nun eine Aufgabe der gegenständlichen Erfindung, eine Strommesseinrichtung anzugeben, die eine hohe Messgenauigkeit, auch bei kleinen zu messenden Strömen aufweist, unempfindlich gegen Fremdfelder ist und keine magnetischen Sättigungseffekte bei DC-Anteilen im zu messenden Strom zeigt.

Diese Aufgabe wird für die Vorrichtung dadurch gelöst, dass seitlich am Aufnahmeteil eine Abschirmeinrichtung aus einem Material mit magnetischer Permeabilität im Bereich der ferromagnetischen oder weichmagnetischen Materialien angeordnet ist, welche die Sensoren zumindest teilweise umgibt, wobei sich die Abschirmeinrichtung aus der Seite des Aufnahmeteils, an dem die Sensoren angeordnet sind, erstreckt.. Diese Anordnung hat die Vorteile einer hohen Messgenauigkeit, da der stromführende Leiter in der Nähe der Sensoren platziert werden kann, einer Unempfindlichkeit gegenüber Fremdfelder durch die Führung der Magnetfelder im Aufnahmeteil und geringer Sättigungseffekte bei DC-Anteilen im zu messenden Strom, da in der Vorrichtung, durch die konstruktionsbedingt großen Luftspalte keine geschlossenen magnetischen Kreise aus magnetischem Material vorhanden sind. Außerdem muss die Strommesseinrichtung den stromführenden Leiter nicht umschließen, was die Montage erheblich erleichtert. Und nicht zuletzt kann die erfindungsgemäße Strommesseinrichtung sehr kostengünstig umgesetzt werden. Mit einer solchen Abschirmeinrichtung werden Fremdmagnetfelder Großteils durch die Abschirmeinrichtung und den Aufnahmeteil, jedoch nicht durch die Sensoren, geführt und beeinflussen daher nicht die Messung.

Die Isolationsfestigkeit kann erhöht werden, was vor allem für die Anwendung in Mittel- und Hochspannungsanlagen von Vorteil ist, wenn das Aufnahmeteil in eine zum stromführenden Leiter hochtrennende Isolationsschicht integriert wird, z.B. indem am Aufnahmeteil ein Isolator angeordnet ist, der die Sensoren, und vorteilhaft auch das Aufnahmeteil, und/oder die Abschirmeinrichtung umgibt. Damit kann je nach geforderter Spannungsfestigkeit eine definierte Isolationsstrecke geschaffen werden. Der zwischen den Abschirmeinrichtungen und dem Aufnahmeteil entstehende Raum wird dazu vorteilhaft mit einem hoch isolierenden Material gefüllt.

Ganz besonders vorteilhaft ist seitlich an gegenüberliegenden Seiten des Aufnahmeteils oder seitlich rund um die Sensoren herum eine solche Abschirmeinrichtung anzuordnen.

Die Fremdfeldunempfindlichkeit kann noch weiter verbessert werden, wenn eine Abdeckeinrichtung aus einem Material hoher Permeabilität vorgesehen ist, die der Seite des Aufnahmeteils, an der die Sensoren angeordnet sind, gegenüberliegend angeordnet ist. Eine solche Abdeckeinrichtung, welche vorzugsweise mit einem Isolator umgeben ist, schirmt auch Fremdmagnetfelder ab, die von einer Quelle herrühren, die der Seite des Aufnahmeteils, an der die Sensoren angeordnet sind, gegenüberliegend angeordnet ist.

Wenn in der Strommesseinrichtung in einem definierten Abstand zu den Sensoren ein konstruktiv definiertes Leiterstück als Teil der Messeinrichtung bereits integriert ist, kann die Strommesseinrichtung bereits nach Fertigung im Werk vorab geeicht werden, was die Montage und den Einsatz erleichtert. Außerdem kann der stromführende Leiter einfacher und sicherer montiert werden.

Aus Gründen der Sicherheit ist es von Vorteil, wenn der Aufnahmeteil und/oder die Abschirmeinrichtung und/oder die Abdeckeinrichtung vollständig von einem Isolator umgeben werden.

Die vorhandenen Teile der Strommesseinrichtung können einfach verwendet werden, um zusätzlich eine Spannungsmesseinrichtung zu realisieren. Dazu wird das Leiterstück zur Ausbildung einer Kapazität mittels eines elektrischen Leiters elektrisch mit der Abdeckeinrichtung verbunden. Diese Kapazität kann dann einfach zur Ermittlung der am stromführenden Leiter anliegenden Spannung ausgewertet werden, z.B. mit einer geeigneten elektronischen Auswerteeinrichtung oder mit Hilfe eines bekannten kapazitiven Teilers.

Die Strommesseinrichtung kann besonders vorteilhaft in einem Isolator integriert werden, wobei die Seite des Aufnahmeteils der Strommesseinrichtung, an der die Sensoren angeordnet sind, dem stromführenden Leiter zugewandt angeordnet wird. Ein Isolator mit integrierter erfindungsgemäßer Strommesseinrichtung hat somit eine Mehrfachfunktion, was ihn besonders vorteilhaft in der praktischen Anwendung macht, nämlich eine mechanische Abstützung des stromführenden Leiters, die Isolation gegen Erde und eine integrierte, hochgenaue, unempfindliche und günstige Strommessung. Falls auch noch eine Spannungsmessung integriert ist, zusätzlich auch die Funktion der Spannungsmessung.

Das Messergebnis wird verbessert, wenn die Strommesseinrichtung im Bereich des stromführenden Leiter angeordnet ist und somit ein gewisser, durch die Isolationsanforderungen bedingter, Minimalabstand zum stromführenden Leiter sichergestellt wird.

Die gegenständliche Erfindung wird nachfolgend anhand der schematischen, beispielhaften und nicht einschränkenden und vorteilhafte Ausgestaltungen zeigenden Figuren 1 bis 6 beschrieben. Dabei zeigt

Fig. 1 eine Ausgestaltung einer Strommesseinrichtung,
Fig. 2 eine Anordnung zur Messung des Stromes eines stromdurchflossenen Leiters mit einer erfindungsgemäßen Strommesseinrichtung,
Fig. 3 die Auswirkung einer Abschirmeinrichtung auf die Fremdfeldempfindlichkeit,
Fig. 4 eine Anordnung zur Messung des Stromes eines stromdurchflossenen Leiters mit einer Abdeckeinrichtung,
Fig. 5 die Auswirkung der Abdeckeinrichtung auf die Fremdfeldempfindlichkeit und
Fig. 6 einen Isolator mit einer integrierten erfindungsgemäßen Strommesseinrichtung.

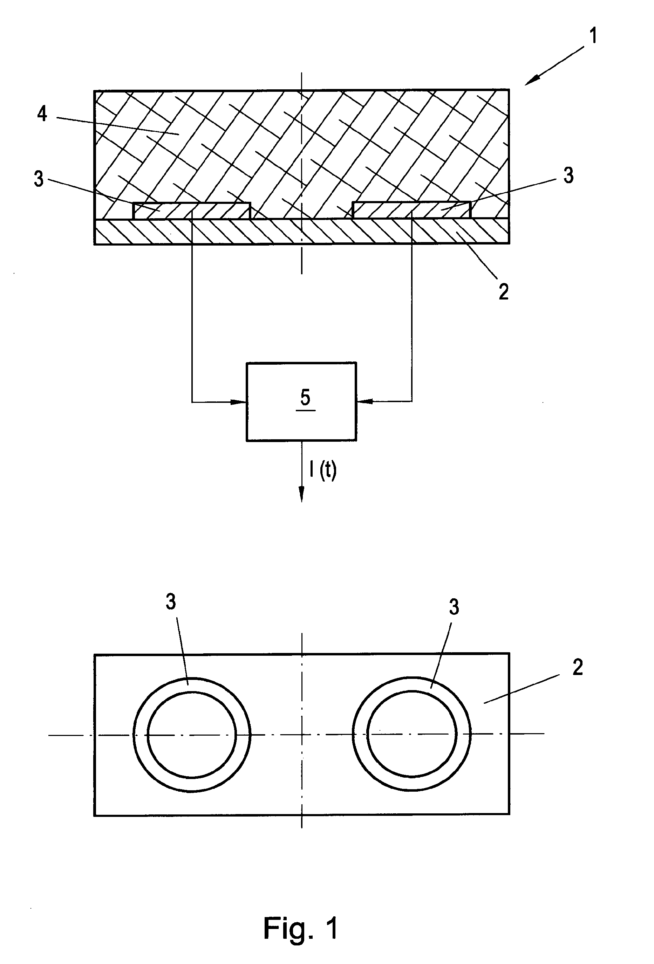

In der Fig. 1 ist eine einfache Ausgestaltung einer Strommesseinrichtung 1 gezeigt, die aus einem Aufnahmeteil 2 aus einem magnetischen Material hoher Permeabilität besteht. Unter hoher Permeabilität werden Permeabilitätszahlen verstanden, die im Bereich der Permeabilitätszahlen der ferromagnetischen bzw.

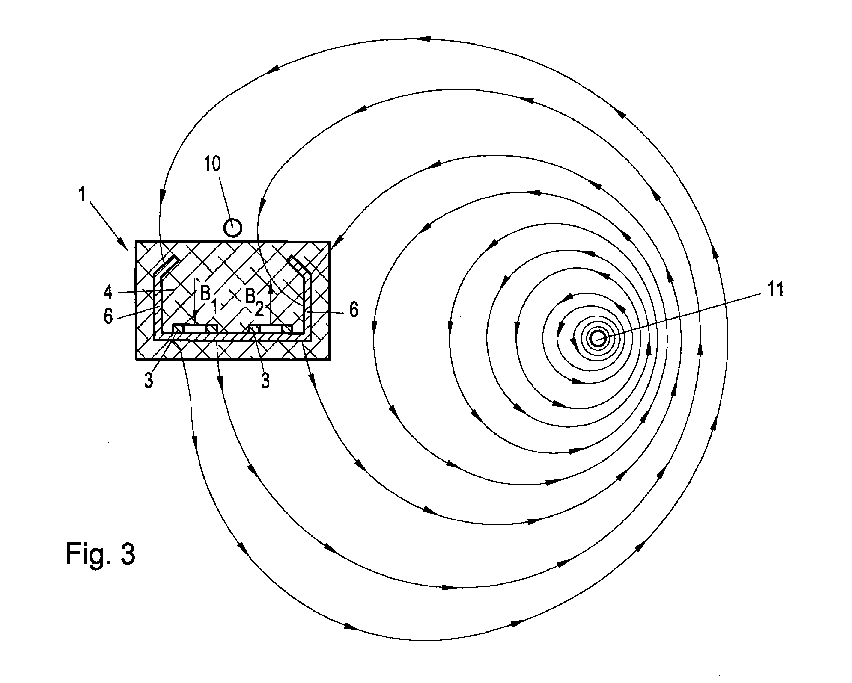

weichmagnetischen Materialien, wie z.B. Fe und Ferrite, Co, Ni, oder darüber liegen, also relative Permeabilitätszahlen im Bereich von 500 bis 500.000. Der Aufnahmeteil 2 ist z.B., wie in Fig. 1 dargestellt, ein dünnes, ebenes, flächiges Plättchen. Der Aufnahmeteil 2 kann aber nahezu beliebig geformt sein, z.B. pfeilförmig gebogen oder auch gekrümmt. Auf einer Seite des Aufnahmeteils 2 sind beabstandet von einander zwei Sensoren 3 zur Messung eines Magnetfeldes, wie z.B. eine toroidförmige Luftspule (wie in Fig. 1 angedeutet) oder ein Hallsensor, angeordnet, wobei die magnetisch wirksamen Achsen der beiden Sensoren 3 jeweils magnetisch gleichsinnig, hier orthogonal, zur Oberfläche des Aufnahmeteiles 2 ausgerichtet sind. Die beiden Sensoren 3 sind hier von einem Isolator 4 umgeben werden, z.B. mit einem Gießharz umgossen, obwohl grundsätzlich auch Luft als Isolator dienen könnte. Weiters wird bevorzugt auch der gesamte Aufnahmeteil 2 von einem Isolator 4 umgeben, z.B. mit einem Gießharz umgossen. Aus Sicherheitsgründen ist vorteilhaft die gesamte Strommesseinrichtung 1 mit einem Isolator 4 umgeben, wie z.B. in Fig. 3 angedeutet.

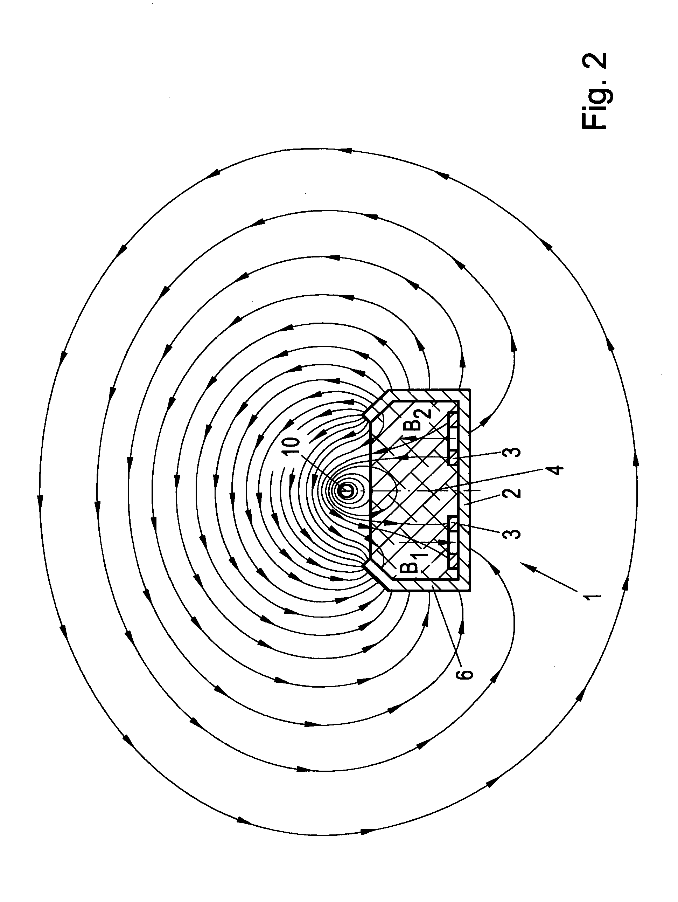

Durch diese Anordnung wird eine Eigenschaft von magnetischen Feldern ausgenutzt, nämlich der Umstand, dass beim Übergang von magnetischen Feldlinien aus niedrig- in hochpermeable Materialien (hier vom Isolator 4 oder von Luft in den hochpermeablen Aufnahmeteil 2 und umgekehrt) die magnetischen Feldlinien (fast) orthogonal zu der sich durch die unterschiedlichen Permeabilitäten ergebenden Trennschicht ein- bzw. austreten. Die beiden Sensoren 3 messen somit die im Wesentlichen orthogonal in den Aufnahmeteil 2 eintretenden sowie austretenden Magnetfelder (angedeutet durch die gegensinnigen magnetischen Flussdichten $B_1$ und $B_2$ in Fig. 2). In einer Auswerteeinheit 5 werden die Messsignale der beiden Sensoren 3, wie weiter unten detaillierter beschrieben, ausgewertet.

Eine erfindungsgemäße Strommesseinrichtung 1 ist in Fig. 2 in einer Anordnung zur Messung eines Stromes durch einen stromführenden Leiter 10 dargestellt. In Fig. 2 sind die durch den durch den Leiter 10 fließenden Strom i(t) entstehenden Feldlinien des Magnetfeldes dargestellt. Ein Teil des Magnetfeldes wird dabei durch den Aufnahmeteil 2 aus einem hochpermeablen Material geführt. Ein weiterer Teil des Magnetfeldes durchdringt den magnetisch unwirksamen Isolator 4 und tritt im Wesentlichen orthogonal in den Aufnahmeteil 2 ein bzw. wieder daraus aus. Da die Feldlinien immer geschlossen sind, schließen sich diese Feldlinien über den Aufnahmeteil 2. Bei einer bevorzugt symmetrischen Anordnung, bei der der Leiter 10 mittig zwischen den beiden Sensoren 3 angeordnet ist, messen die beiden Sensoren 3 folglich denselben Magnetfeldanteil (der proportional zum Strom durch den Leiter 10 ist) jedoch mit unterschiedlicher Richtung. Die Feldlinien, die nicht durch den Isolator 4 durchtreten schließen sich zum Teil ebenfalls über den Aufnahmeteil 2, werden aber nicht gemessen. Der Aufnahmeteil 2 dient somit auch zur Führung des Magnetfeldes. Im praktischen Einsatz der Strommesseinrichtung 1 wird diese vor einer Messung zu eichen sein.

In einer bevorzugten Ausführung ist der Aufnahmeteil 2 ein symmetrischer Teil, dessen erste Symmetrieachse parallel zur Leitersymmetrieachse verläuft und dessen zweite Symmetrieachse die Leitersymmetrieachse schneidet, wobei die Sensoren 3 am Aufnahmeteil 2 symmetrisch bezüglich der zweiten Symmetrieachse angeordnet sind.

An der Strommesseinrichtung 1 ist weiters seitlich am Aufnahmeteil 2 eine Abschirmeinrichtung 6 angeordnet, die sich aus der Seite des Aufnahmeteils 2, an der die Sensoren 3 angeordnet sind, erstreckt und bevorzugt im Wesentlichen parallel zum Leiter 10 angeordnet ist. Die Abschirmeinrichtung 6 und der Aufnahmeteil 2 sind dabei bevorzugt magnetisch miteinander verbunden und nicht durch einen Isolator getrennt. Bevorzugt ist am Aufnahmeteil 2 seitlich an gegenüberliegenden Seiten eine Abschirmeinrichtung 6 vorgesehen, was bei parallel nebeneinander verlaufenden Leitern ausreicht, oder es wird der Aufnahmeteil 2 seitlich rundherum mit einer solchen Abschirmeinrichtung 6 umgeben, wobei oberhalb der Sensoren 3 eine Öffnung verbleiben muss, damit das Magnetfeld zu den Sensoren 3 gelangen kann. Die Abschirmeinrichtung 6 wird ebenfalls wieder aus einem Material hoher Permeabilität gebildet. In einer einfachen Ausführung werden der Aufnahmeteil 2 und die Abschirmeinrichtung 6 als ein Teil gefertigt, z.B. durch Biegen eines Bleches. Der zwischen den Abschirmeinrichtungen 6 und dem Aufnahmeteil 2 entstehende Raum wird vorteilhaft mit einem hoch isolierenden Material gefüllt, z.B. mit einem Gießharz ausgegossen. Die Abschirmeinrichtung 6 dient dabei der Führung des Magnetfeldes und verringert insbesondere den Einfluss von Fremdfeldern auf die Messung der Strommesseinrichtung, wie in Fig. 3 dargestellt. Aus Sicherheitsgründen ist auch die Abschirmeinrichtung 6 bevorzugt mit einem Isolator 4 umgeben, wie z.B. in Fig. 3 angedeutet.

Es ist aber selbstverständlich auch denkbar, mehr als zwei Sensoren 3 anzuordnen, wobei die Sensoren 3 bevorzugt wiederum symmetrisch angeordnet werden. Die Ermittlung des zu messenden Stromes in der Auswerteeinheit 5 kann einfach daran angepasst werden.

In Fig. 3 wird der Einfluss eines weiteren stromdurchflossenen Leiters 11 in der näheren Umgebung seitlich der Strommesseinrichtung 1 dargestellt. Wie aus Fig. 3 ersichtlich werden Fremdfelder durch die Abschirmeinrichtung 6 von den Sensoren 3 abgeschirmt. Solche Fremdfelder werden dabei durch die Abschirmeinrichtung 6 und den Aufnahmeteil 2 geführt und beeinflussen nicht (bzw. nur in sehr geringem Maße) die Messung der Strommesseinrichtung 1.

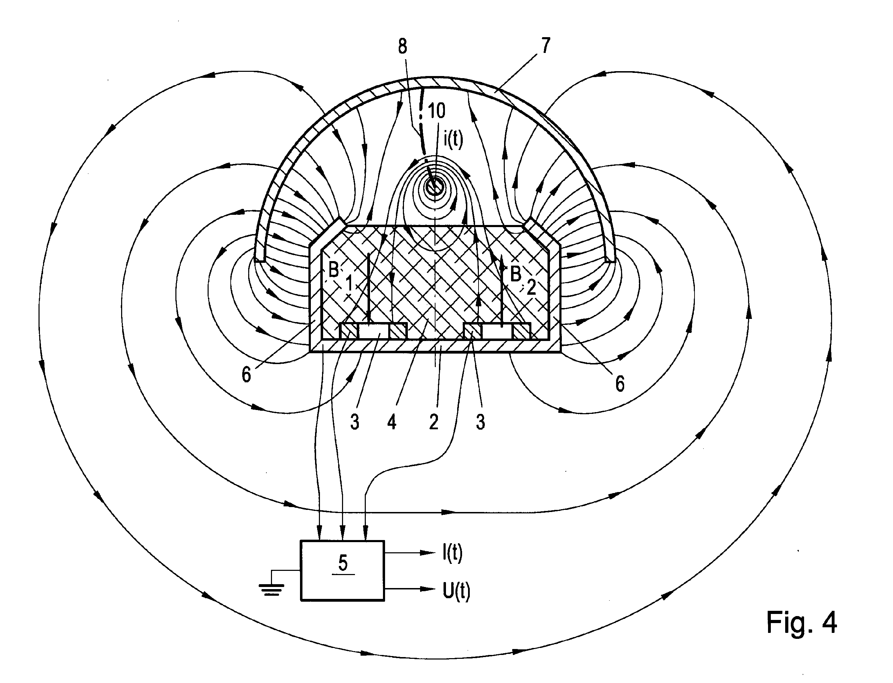

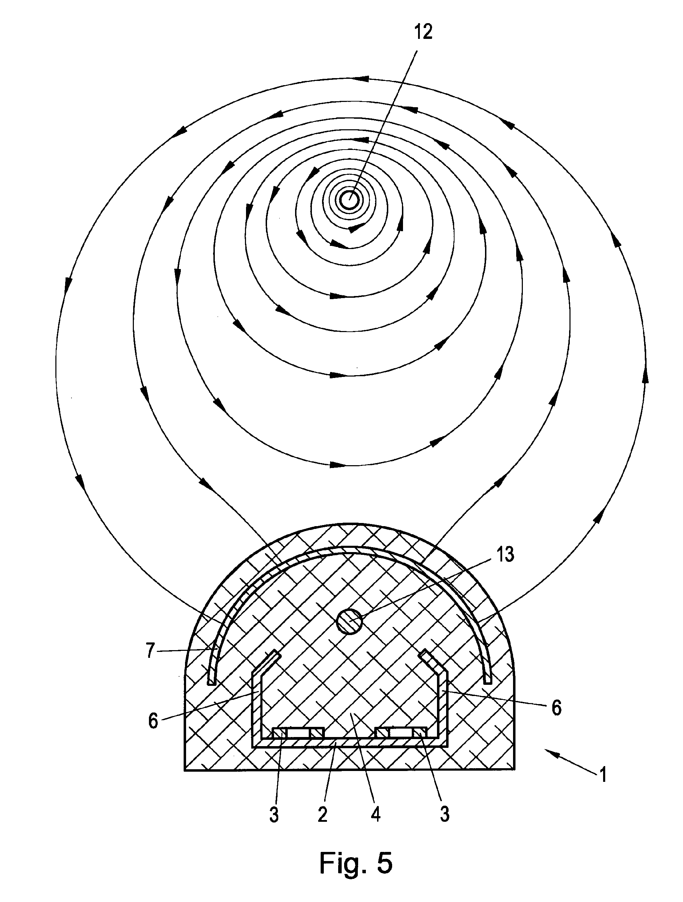

Eine weitere Verringerung der Fremdfeldempfindlichkeit wird durch eine Abdeckeinrichtung 7, wie in Fig. 4 dargestellt, erreicht, die den Leiter 10 und die Strommesseinrichtung 1 teilweise umgibt, wobei der Leiter 10 zwischen Abdeckeinrichtung 7 und Strommesseinrichtung 1 angeordnet wird und die der Seite des Aufnahmeteils 2, an der die Sensoren 3 angeordnet sind, gegenüberliegend angeordnet ist. Die Abdeckeinrichtung 7 ist dabei wiederum aus einem Material mit hoher Permeabilität gebildet und kann z.B. als gebogenes Blech ausgeführt sein. Das Material hoher magnetischer Permeabilität der Abdeckeinrichtung 7 sollte, insbesondere aus Gründen der Sicherheit, auch mit einer Isolationsschicht umgeben sein, z.B. mit einem Gießharz umgossen sein. Mit einer solchen Abdeckeinrichtung 7 wird die Fremdfeldempfindlichkeit auch gegenüber benachbarter stromdurchflossener Leiter 12, die nicht seitlich, sondern oberhalb des Leiters 10 bzw. der Strommesseinrichtung 1 angeordnet sind, verringert, wie in Fig. 5 angedeutet. Daraus ist ersichtlich, dass die Feldlinien, die von einem solchen Leiter 12 ausgehen, durch die Abdeckeinrichtung 7 geführt werden und diese Fremdfelder praktisch nicht mehr in die Strommesseinrichtung 1 eindringen und somit auch die Messung durch die Sensoren 3 nicht mehr beeinflussen können. Aus Sicherheitsgründen ist bevorzugt auch zwischen der Abdeckeinrichtung 7 und der Abschirmeinrichtung 6 bzw. zwischen Abdeckeinrichtung 7 und dem Aufnahmeteil 2 ein Isolator 4 angeordnet. Bevorzugt wird die gesamte Anordnung mit einem Isolator 4 umgeben, z.B. mit einem Gießharz aus- bzw. umgossen, wie in Fig. 5 angedeutet.

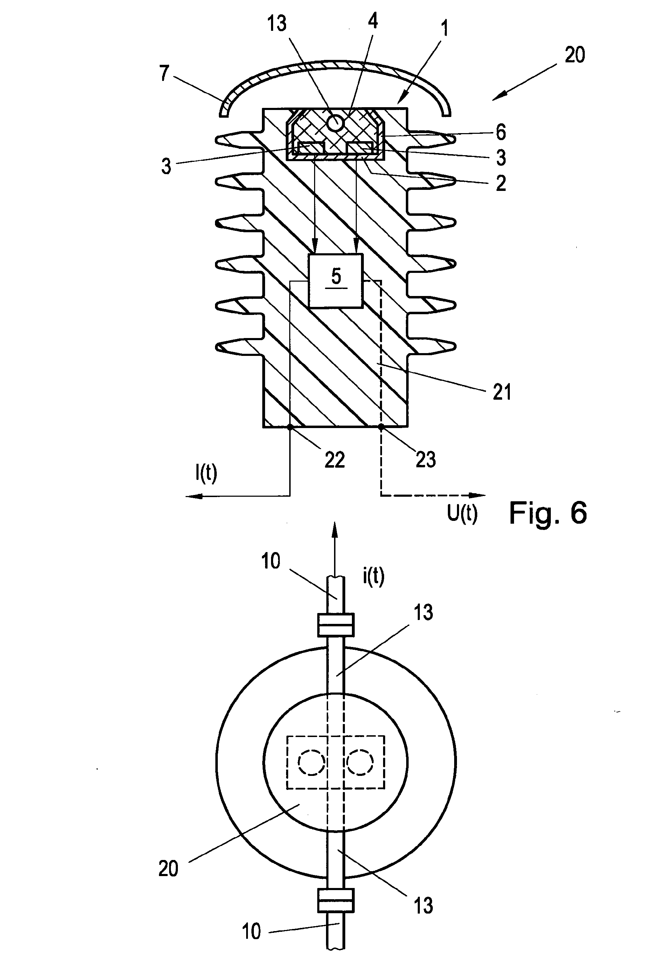

In der Strommesseinrichtung 1 kann auch ein Leiterstück 13 integriert sein, z.B. in den Isolationsbereich 4 miteingegossen, an dessen Enden der stromführende Leiter 10 einfach befestigt (z.B. geschraubt, geklemmt, etc.) werden kann, um definierte mechanische, geometrische und magnetische Verhältnisse zwischen den Sensoren 3 und dem Leiter 10 bzw. dem Leiterstück 13 sicherzustellen (siehe Fig. 5 und 6). Dies hätte den Vorteil, dass die Strommesseinrichtung 1 bereits vor der Installation abgeglichen und kalibriert werden könnte, was die Montage und Inbetriebnahme der Strommesseinrichtung 1 sehr vereinfachen würde. Falls die Strommesseinrichtung 1 in einen Isolator 20 integriert wird oder vollständig von einem Isolator 4 umgeben wird, wie in Fig. 5 oder 6 dargestellt, ragt das Leiterstück 13 vorteilhaft aus dem Isolator 20 bzw. der Strommesseinrichtung 1 heraus, um daran einen Leiter 10 befestigen zu können.

Eine weitere vorteilhafte Ausführungsvariante ergibt sich, wenn man die Abdeckeinrichtung 7 mit einer elektrischen Leitung 8 elektrisch leitend mit dem stromführenden Leiter 10 bzw. mit einem in der Strommesseinrichtung 1 integrierten Leiterstück 13 verbindet, wie z.B. in Fig. 4 durch die strichpunktierte Linie angedeutet, wodurch sich zwischen der Abdeckeinrichtung 7 und der Abschirmeinrichtung 6 samt Aufnahmeteil 2 eine Kapazität ergibt. Diese Kapazität kann zusammen mit einer weiteren Kapazität (z.B. als Kondensator) z.B. in Form eines kapazitiven Teilers oder im Zusammenhang mit einer Auswerteeinheit 5, z.B. einer elektronische Auswerteschaltung mit virtuellem Bezugspotential, vorzugsweise virtuelles Erdpotential, als Spannungsmessrichtung verwendet wird. Zur Ermittlung der am Leiter 10

bzw. am Leiterstück 13 anliegenden Spannung u(t) kann natürlich die Auswerteeinheit 5 verwendet werden, es kann aber auch eine separate Auswerteeinrichtung zur Ermittlung der Spannung U(t), die z.B. am Ausgang der Auswerteeinheit 5 als zur messenden Leiterspannung u(t) proportionaler Messwert ausgegeben wird, vorgesehen sein. Die geforderte galvanische Trennung (Isolationsbarriere) zwischen dem an der Abschirmeinrichtung 7 anliegenden elektrischen Potential des stromführenden Leiters 10 und dem an der Abschirmeinrichtung 6 sowie dem am Aufnahmeteil 2 anliegenden elektrischen Potential kann durch entsprechende elektrische Isolation zwischen allen Teilen mit unterschiedlichen elektrischen Potentialen hergestellt werden.

Die Messsignale der beiden Sensoren 3 werden in der Auswerteeinheit 5 derart ausgewertet, dass die Messsignale von Magnetfeldern unterschiedlicher Richtung addiert und die Messsignale von gleichgerichteten Magnetfeldern subtrahiert werden. Dies erreicht man unter Berücksichtigung der Vorzeichen der Messsignale z.B. einfach durch eine Differenzbildung der beiden Messsignale der beiden Sensoren 3. Durch die Differenzbildung der Messsignale der beiden Sensoren 3 für jene Magnetfelder, die die beiden Sensoren 3 in gleicher Richtung durchdringen, reduziert sich die Fremdfeldempfindlichkeit wiederum erheblich. Dies gilt speziell für Fremdfelder, die durch stromführende Leiter 11 verursacht werden, die sich seitlich neben dem eigentlichen Leiter 10 befinden. Aufgrund der durch die gegebene Anordnung bedingten strikten Proportionalität zwischen den jeweils in den beiden Sensoren 3 wirksamen magnetischen Flüssen Φ und dem zu messenden Strom kann nach Messung der beiden magnetischen Flüsse Φ direkt auf den zu messenden Strom geschlossen werden. Durch Anwendung des Induktionsgesetzes

$$E(t) \equiv n.\frac{d}{dt}\Phi(t),$$ erkennt man, dass sich der die Spule mit der Windungszahl n durchdringende magnetische Fluss Φ(t) durch zeitliche Integration der in der Spule induzierten Spannung E(t) ermitteln lässt.

Falls das Magnetfeld also mit Spulen detektiert wird, muss in der Auswerteeinheit 5 auch ein Integrator vorgesehen sein, da zur Bestimmung des magnetischen Flusses Φ (der zum eigentlich zu messenden Strom proportional ist) die an den beiden Spulen auftretenden induzierten Spannungen als Funktion der Zeit zu integrieren sind (Induktionsgesetz).

Als Sensor 3 kann auch ein hinlänglich bekannter Hall-Sensor eingesetzt werden, der es ermöglicht, auch Gleichströme bzw. einen Gleichstromanteil zu messen. In diesem Fall ist auch kein Integrator erforderlich.

Eine oben beschriebene Strommesseinrichtung 1 kann einfach in einen Isolator 20 integriert werden, wie in Fig. 6 dargestellt. Der Isolator 20 besteht im Wesentlichen aus einem Isolationskörper 21 aus isolierendem Material, z.B. ein Gießharz. In den Isolationskörper ist die Strommesseinrichtung 1 integriert, z.B. fix in den Isolationskörper 21 miteingegossen. Die Strommesseinrichtung 1 ist dabei so zu integrieren, dass die Seite des Aufnahmeteils 2 der Strommesseinrichtung 1, an der die Sensoren 3 angeordnet sind, dem stromführenden Leiter zugewandt angeordnet ist. Weiters wird die Strommesseinrichtung 1 vorteilhaft in dem Bereich des Isolators 20 angeordnet, der den stromführenden Leiter 10 kontaktiert, um sicherzustellen, dass die Strommesseinrichtung 1 aus Gründen der Messgenauigkeit in der Nähe des stromführenden Leiters 10 bzw. des Leiterstückes 13 angeordnet ist. Die Strommesseinrichtung 1 kann dabei den Isolator 20 nach außen auch teilweise abschließen, wie z.B. in Fig. 6 dargestellt. Außerdem kann auch die Auswerteeinheit 5, mit eventuell vorhandener Elektronik, in den Isolationskörper 21 integriert werden. An einem Ausgang 22 am Isolator 20 kann dann direkt ein dem messenden Strom i(t) proportionales Messsignal I(t) ausgegeben werden, das entsprechend weiterverarbeitet werden kann. Falls auch eine Spannungsmessung wie oben beschrieben realisiert ist, kann am Isolator 20 ein zusätzlicher Ausgang 23 für das Spannungssignal U(t) vorgesehen sein. Die Auswerteeinheit 5 kann aber auch außerhalb des Isolators 20 angeordnet werden. In diesem Fall müssten die Messsignale der Sensoren 3 nach außen geführt werden. Zusätzlich kann auch noch eine Abdeckeinrichtung 7, wie oben beschrieben, am Isolator 20 angeordnet werden. Die Abdeckeinrichtung 7 kann aber ebenfalls in den Isolator 20 integriert sein, z.B. miteingegossen sein. Eine solche Abdeckeinrichtung 7 könnte z.B. einfach auf den Isolator 20 gesteckt und/oder mit dem stromführenden Leiter elektrisch verbunden und, wie oben beschrieben, in vorteilhafter Weise zur Spannungsmessung verwendet werden.

Im Isolator 20 kann weiters auch eine Spannungsmessung integriert werden, z.B. eine kapazitive Spannungsmessung wie in der FR 2 698 695 A2 beschrieben. Solche Spannungsmesseinrichtungen sind in vielfältigen Ausgestaltungen an sich hinlänglich bekannt. Eine erfindungsgemäße Spannungsmesseinrichtung ist z.B. oben beschrieben.

**Patentansprüche**

1. Strommesseinrichtung zur galvanisch getrennten Messung von Strömen mit einem Aufnahmeteil (2) aus einem Material mit magnetischer Permeabilität im Bereich der ferromagnetischen oder weichmagnetischen Materialien auf dem an einer Seite eine Mehrzahl von Sensoren (3) zur Messung der im Wesentlichen orthogonal zum Aufnahmeteil (2) ausgerichteten Magnetfelder ($B_1$, $B_2$) angeordnet sind, wobei eine Auswerteeinheit (5) vorgesehen ist, die die Messsignale der Sensoren (3) zur Bestimmung des zu messenden Stromes (i) auswertet, **dadurch gekennzeichnet, dass** seitlich am Aufnahmeteil (2) eine Abschirmeinrichtung (6) aus einem Material mit magnetischer Permeabilität im Bereich der ferromagnetischen oder weichmagnetischen Materialien angeordnet ist, welche die Sensoren (3) zumindest teilweise umgibt, wobei sich die Abschirmeinrichtung (6) aus der Seite des Aufnahmeteils (2), an dem die Sensoren (3) angeordnet sind, erstreckt.

2. Strommesseinrichtung nach Anspruch 1, **dadurch gekennzeichnet, dass** am Aufnahmeteil (2) weiters ein Isolator (4) angeordnet ist, der die Sensoren (3) und/oder den Aufnahmeteil (2) und/oder die Abschirmeinrichtung (6) umgibt.

3. Strommesseinrichtung nach Anspruch 2, **dadurch gekennzeichnet, dass** der zwischen der Abschirmeinrichtung (6) und dem Aufnahmeteil (2) entstehende Raum mit einem isolierenden Material gefüllt ist.

4. Strommesseinrichtung nach einem der Ansprüche 1 bis 3, **dadurch gekennzeichnet, dass** die Abschirmeinrichtung (6) seitlich an gegenüberliegenden Seiten des Aufnahmeteils (2) oder seitlich rund um die Sensoren (3) herum angeordnet ist.

5. Strommesseinrichtung nach einem der Ansprüche 1 bis 4, **dadurch gekennzeichnet, dass** eine, vorzugsweise von einem Isolator umgebene, Abdeckeinrichtung (7) aus einem Material mit magnetischer Permeabilität im Bereich der ferromagnetischen oder weichmagnetischen Materialien vorgesehen ist, die der Seite des Aufnahmeteils (2), an der die Sensoren (3) angeordnet sind, gegenüberliegend angeordnet ist.

6. Strommesseinrichtung nach einem der Ansprüche 1 bis 5, **dadurch gekennzeichnet, dass** in der Strommesseinrichtung (1) in einem definierten Abstand zu den Sensoren (3) ein definiertes, den zu messenden Strom führendes Leiterstück (13) angeordnet ist.

7. Strommesseinrichtung nach Anspruch 6, **dadurch gekennzeichnet, dass** das Leiterstück (13) zur Ausbildung einer Kapazität mittels eines elektrischen Leiters (8) elektrisch mit der Abdeckeinrichtung (7) verbunden ist.

8. Strommesseinrichtung nach Anspruch 6 oder 7, **dadurch gekennzeichnet, dass** das Leiterstück (13) von einem Isolator umgeben sind.

9. Anordnung zur Strommessung mit einem stromführenden Leiter (10) und einer Strommesseinrichtung (1) nach einem der Ansprüche 1 bis 8, **dadurch gekennzeichnet, dass** die Seite des Aufnahmeteils (2) der Strommesseinrichtung (1), an der die Sensoren (3) angeordnet sind, dem Leiter (10) bzw. dem Leiterstück (13) zugewandt angeordnet ist.

**10.** Anordnung nach Anspruch 9, **dadurch gekennzeichnet, dass** der Leiter (10) bzw. das Leiterstück (13) zwischen Strommesseinrichtung (1) und Abdeckeinrichtung (7) angeordnet ist.

**11.** Anordnung nach Anspruch 9 oder 10, **dadurch gekennzeichnet, dass** eine Auswerteeinheit (5) vorgesehen ist, die die im Falle eines elektrisch mit der Abdeckeinrichtung (7) verbundenen Leiters (10) bzw. Leiterstückes (13) sich zwischen Abdeckeinrichtung (7) und Aufnahmeteil (2) und/oder Abschirmeinrichtung (6) ergebende Kapazität, eventuell zusammen mit einer weiteren Kapazität in Form eines kapazitiven Teilers, zur Ermittlung der am Leiter (10) bzw. am Leiterstück (13) anliegenden Spannung (u) auswertet.

**12.** Isolator mit einem Isolatorkörper (21) in dem eine Strommesseinrichtung (1) nach einem der Ansprüche 1 bis 8 angeordnet ist, wobei die Seite des Aufnahmeteils (2) der Strommesseinrichtung (1), an der die Sensoren (3) angeordnet sind, einem Leiter (10) bzw. einem Leiterstück (13) zugewandt angeordnet ist.

**13.** Isolator nach Anspruch 12, **dadurch gekennzeichnet, dass** die Strommesseinrichtung (1) im Isolator (20) im Bereich des stromführenden Leiters (10) angeordnet ist.

**14.** Isolator nach Anspruch 12 oder 13 mit einer Abdeckeinrichtung (7), **dadurch gekennzeichnet, dass** der Leiter (10) bzw. das Leiterstück (13) zwischen Strommesseinrichtung (1) und Abdeckeinrichtung (7) angeordnet ist.

**15.** Isolator nach einem der Ansprüche 12 bis 14 mit einer Abdeckeinrichtung (7), **dadurch gekennzeichnet, dass** eine Auswerteeinheit (5) vorgesehen ist, die die im Falle eines elektrisch mit der Abdeckeinrichtung (7) verbundenen Leiters (10) bzw. Leiterstückes (13) sich zwischen Abdeckeinrichtung (7) und Aufnahmeteil (2) und/oder Abschirmeinrichtung (6) ergebende Kapazität, eventuell zusammen mit einer weiteren Kapazität in Form eines kapazitiven Teilers, zur Ermittlung der am Leiter (10) bzw. am Leiterstück (13) anliegenden Spannung (u) auswertet.

**Claims**

**1.** A current measurement unit for the galvanically isolated measurement of currents, comprising a receiving portion (2) made from a material with magnetic permeability in the range of ferromagnetic or magnetically soft materials, on one side of which a plurality of sensors (3) for measuring the magnetic fields $(B_1, B_2)$ are provided, which are orientated substantially orthogonally to the receiving portion (2), wherein an evaluation unit (5) for evaluating the measurement signals of the sensors (3) for determining the current (i) to be measured is provided, **characterized in that** a shielding unit (6) made from a material having magnetic permeability in the range of the ferromagnetic or magnetically soft materials is laterally provided on the receiving portion (2), which shielding unit at least partially surrounds the sensors (3), wherein the shielding unit (6) extends from the side of the receiving portion (2) on which the sensors (3) are located.

**2.** The current measurement unit as claimed in claim 1, **characterized in that** further an isolator (4) is provided on the receiving portion (2), which isolator surrounds the sensors (3) and/or the receiving portion (2) and/or the shielding unit (6).

**3.** The current measurement unit as claimed in claim 2, **characterized in that** the space created between the shielding unit (6) and the receiving portion (2) is filled with an insulating material.

**4.** The current measurement unit as claimed in any one of claims 1 to 3, **characterized in that** the shielding unit (6) is located laterally on opposite sides of the receiving portion (2) or laterally around the sensors (3).

**5.** The current measurement unit as claimed in any one of claims 1 to 4, **characterized in that** a cover unit (7), which is preferably surrounded by an isolator and which is made from a material having magnetic permeability in the range of the ferromagnetic or magnetically soft materials, is located on the side opposite the side of the receiving portion (2), on which the sensors (3) are located.

**6.** The current measurement unit as claimed in any one of claims 1 to 5, **characterized in that** a defined conductor piece (13) carrying the current to be measured is provided in the current measurement unit (1) at a defined distance from the sensors (3).

**7.** The current measurement unit as claimed in claim 6, **characterized in that** the conductor piece (13) is electrically connected to the cover unit (7) for forming a capacity by means of an electric conductor (8).

**8.** The current measurement unit as claimed in claim 6 or 7, **characterized in that** the conductor piece (13) is surrounded by an isolator.

**9.** An assembly for measuring current, comprising a current-carrying conductor (10) and a current measurement unit (1) as claimed in any one of claims 1 to 8, **characterized in that** the side of the receiving portion (2) of the current measurement unit (1), on which the sensors (3) are located, is oriented such that it faces the conductor (10) or the conductor piece (13).

10. The assembly as claimed in claim 9, **characterized in that** the conductor (10) or the conductor piece (13) is provided between the current measurement unit (1) and the cover unit (7).

11. The assembly as claimed in claim 9 or 10, **characterized in that** an evaluation unit (5) is provided for evaluating the capacity that is created between the cover unit (7) and the receiving portion (2) and/or the shielding unit (6) in the case of a conductor (10) or conductor piece (13) electrically connected to the cover unit (7), potentially together with a further capacity in the form of a capacitative divider, for determining the voltage (u) present on the conductor (10) or on the conductor piece (13).

12. An isolator comprising an isolator body (21), in which a current measurement unit (1) as claimed in any one of claims 1 to 8 is provided, wherein the side of the receiving portion (2) of the current measurement unit (1), on which the sensors (3) are located, is oriented such that it faces a conductor (10) or a conductor piece (13).

13. The isolator as claimed in claim 12, **characterized in that** the current measurement unit (1) is provided in the isolator (20) in the area of the current-carrying conductor (10).

14. The isolator as claimed in claim 12 or 13, comprising a cover unit (7), **characterized in that** the conductor (10) or the conductor piece (13) is provided between the current measurement unit (1) and the cover unit (7).

15. The isolator as claimed in any of claims 12 to 14 with a cover unit (7), **characterized in that** an evaluation unit (5) is provided for evaluating a capacity created between the cover unit (7) and the receiving portion (2) and/or the shielding unit (6) in the case of a conductor (10) or conductor piece (13) electrically connected to the cover unit (7), potentially together with a further capacity in the form of a capacitative divider for determining the voltage (u) present on the conductor (10) or on the conductor piece (13).

**Revendications**

1. Moyen de mesure de courant servant à mesurer des courants de façon galvaniquement séparée, ledit moyen de mesure de courant comportant une partie de réception (2) en un matériau à perméabilité magnétique dans la gamme des matériaux ferromagnétiques ou magnétiques doux sur laquelle sont disposés, sur un côté, une pluralité de capteurs (3) servant à mesurer les champs magnétiques (B1, B2), orientés sensiblement orthogonalement à la partie de réception (2), une unité d'évaluation (5) étant prévue qui évalue les signaux de mesure des capteurs (3) pour déterminer le courant (i) à mesurer, **caractérisé en ce que** latéralement sur la partie de réception (2) est disposé un moyen de blindage (6) en un matériau à perméabilité magnétique dans la gamme des matériaux ferromagnétiques ou magnétiques doux qui entoure les capteurs (3) au moins partiellement, le moyen de blindage (6) s'étendant depuis le côté de la partie de réception (2) sur laquelle les capteurs (3) sont disposés.

2. Moyen de mesure de courant selon la revendication 1, **caractérisé en ce que** sur la partie de réception (2) est en outre disposé un isolateur (4) qui entoure les capteurs (3) et/ou la partie de réception (2) et/ou le moyen de blindage (6).

3. Moyen de mesure de courant selon la revendication 2, **caractérisé en ce que** l'espace ménagé entre le moyen de blindage (6) et la partie de réception (2) est rempli d'un matériau isolant.

4. Moyen de mesure de courant selon l'une des revendications 1 à 3, **caractérisé en ce que** le moyen de blindage (6) est disposé latéralement sur des côtés opposés de la partie de réception (2) ou latéralement tout autour des capteurs (3).

5. Moyen de mesure de courant selon l'une des revendications 1 à 4, **caractérisé en ce qu'**il est prévu un moyen de recouvrement (7), en matériau à perméabilité magnétique dans la gamme des matériaux ferromagnétiques ou magnétiques doux, qui est entouré de préférence d'un isolateur et qui est disposé en face du côté de la partie de réception (2) au niveau duquel sont disposés les capteurs (3).

6. Moyen de mesure de courant selon l'une des revendications 1 à 5, **caractérisé en ce que**, dans le dispositif de mesure de courant (1), un élément conducteur défini (13), conduisant le courant à mesurer, est disposé à une distance définie des capteurs (3).

7. Moyen de mesure de courant selon la revendication 6, **caractérisé en ce que** l'élément conducteur (13) est relié électriquement au moyen de recouvrement (7) pour former une capacité à l'aide d'un conducteur électrique (8).

8. Moyen de mesure de courant selon la revendication 6 ou 7, **caractérisé en ce que** l'élément conducteur (13) est entouré par un isolateur.

9.  Ensemble de mesure de courant comportant un conducteur de courant (10) et un dispositif de mesure de courant (1) selon l'une des revendications 1 à 8, **caractérisé en ce que** le côté de la partie de réception (2) du moyen de mesure de courant (1) sur lequel les capteurs (3) sont disposés est disposé en étant dirigé vers le conducteur (10) et l'élément conducteur (13).

10. Ensemble selon la revendication 9, **caractérisé en ce que** le conducteur (10) ou l'élément conducteur (13) est disposé entre le moyen de mesure de courant (1) et le moyen de recouvrement (7).

11. Ensemble selon la revendication 9 ou 10, **caractérisé en ce qu'**il est prévu une unité d'évaluation (5) qui évalue la capacité, obtenue entre le moyen de recouvrement (7) et la partie de réception (2) et/ou le moyen de blindage (6) dans le cas d'un conducteur (10) ou d'un élément conducteur (13) relié électriquement au moyen de recouvrement (7), éventuellement conjointement avec une autre capacité se présentant sous la forme d'un diviseur capacitif, pour déterminer la tension (U) appliquée sur le conducteur (10) ou sur l'élément conducteur (13).

12. Isolateur comportant un corps (21) dans lequel est disposé un moyen de mesure de courant (1) selon l'une des revendications 1 à 8, le côté de la partie de réception (2) du moyen de mesure de courant (1), au niveau duquel les capteurs (3) sont disposés, étant disposé en étant dirigé vers un conducteur (10) ou un élément conducteur (13).

13. Isolateur selon la revendication 12, **caractérisé en ce que** le moyen de mesure de courant (1) est disposé dans l'isolateur (20) dans la zone du conducteur de courant (10).

14. Isolateur selon la revendication 12 ou 13 comportant un moyen de recouvrement (7), **caractérisé en ce que** le conducteur (10) ou l'élément conducteur (13) est disposé entre le moyen de mesure de courant (1) et le moyen de recouvrement (7).

15. Isolateur selon l'une des revendications 12 à 14 comportant un moyen de recouvrement (7), **caractérisé en ce qu'**il est prévu une unité d'évaluation (5) qui évalue la capacité, obtenue entre le moyen de recouvrement (7) et la partie de réception (2) et/ou le moyen de blindage (6) dans le cas d'un conducteur (10) ou d'un élément conducteur (13) relié électriquement au moyen de recouvrement (7), éventuellement conjointement avec une autre capacité se présentant sous la forme d'un diviseur capacitif, pour déterminer la tension (U) appliquée sur le conducteur (10) ou l'élément conducteur (13).

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0123899 A1
- FR 2698695 A2

- EP 0772046 A2